# EUROPEAN PATENT SPECIFICATION

(11) **EP 3 269 027 B1**
(45) Date of publication and mention of the grant of the patent: **01.05.2019**
(21) Application number: 16710646.7
(22) Date of filing: 11.03.2016
(51) Int. Cl.: H02M 1/08, H02M 3/155, H02M 3/335

(54) **COMBINATORIAL/SEQUENTIAL PULSE WIDTH MODULATION**
KOMBINATORISCHE/SEQUENZIELLE PULSWEITENMODULATION
MODULATION DE LARGEUR D'IMPULSION COMBINATOIRE/SÉQUENTIELLE

(30) Priority: 12.03.2015 US 201562132025 P; 09.03.2016 US 201615064843
(43) Date of publication of application: 17.01.2018
(73) Proprietor: Microchip Technology Incorporated, Chandler, AZ 85224-6199 (US)
(72) Inventor: KRIS, Bryan, Gilbert, Arizona 85298 (US); BOWLING, Stephen, Chandler, Arizona 85225 (US); DUMAIS, Alex, Gilbert, Arizona 85297 (US)
(74) Representative: sgb europe
(86) International application number: PCT/US2016/021945
(87) International publication number: WO 2016/145284

(56) References cited:
- US-A1- 2010 122 007
- US-A1- 2014 136 876
- G Venkatesan ET AL: "High Efficiency Sequential Switching HPWM Inverter based UPS", DIGEST OF THE PROCEEDINGS OF THE WSEAS CONFERENCES August, September, October, November 2003, 11 August 2003 (2003-08-11), XP055279529, Retrieved from the Internet: URL:http://www.wseas.us/e-library/conferen ces/digest2003/papers/461-138.pdf [retrieved on 2016-06-10]

## Description

The present disclosure relates to combinatorial pulse width modulation (PWM), in particular, to PWM modules and peripheral units used in microcontrollers comprising such a combinatorial PWM module.

Power conversion applications are becoming increasingly sophisticated. Many power conversion circuits use multiple PWM generators to control the flow of power. Often there are multiple stages of PWM controlled circuitry, where the PWM required for a later stage is dependent upon what occurred in an earlier stage (such as synchronous rectification). When the behavior of the earlier stage PWM is dependent upon external asynchronous events, it becomes difficult to create the required PWM for the subsequent stages.

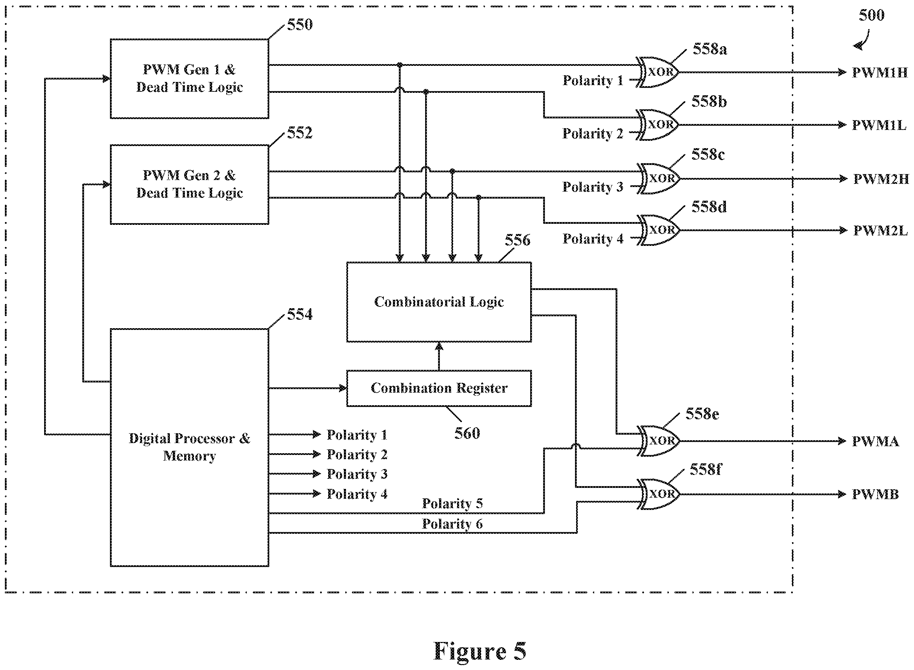

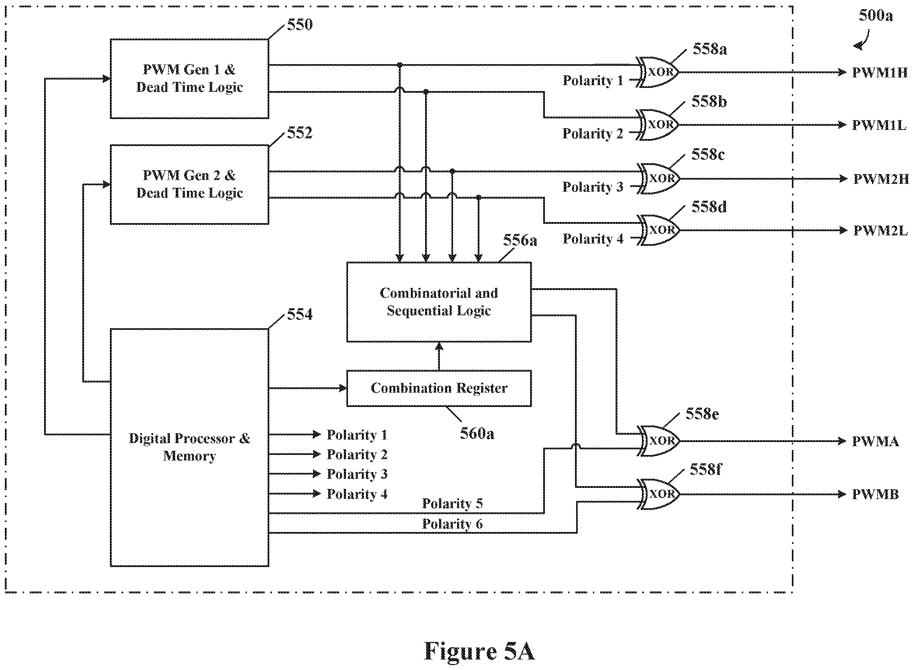

Synchronous Rectifiers, *e*.*g*., synchronously driven field effect transistors (Sync-FETs), are widely used due to their superior power efficiency compared to standard rectifier diodes. The control of synchronous rectifiers is challenging due to the need to be reactive to what is happening in the primary power conversion stage in front of the synchronous rectifiers. Existing synchronous rectifier control methods require additional control circuitry, or additional computation resources to plan and react to events (such as current limits) in proceeding power stages. Figure 5 shows a typical application of devices driven with a plurality of PWM signal and used in a switched mode power supply (SMPS).

Historically, PWM modules were either analog designs, or very simple digital designs used for motor control. Heretofore, complex computation and/or analog circuits have been required for downstream control of power devices such as synchronous rectifiers as one example.

The article "High Efficiency Sequential Switching HPWM Inverter based UPS" by G. Venkatesan et al., published in Digest of the Proceedings of the WSEAS Conferences, 11 August 2008 discloses a new methodology in the inverter control. US Patent Application Publication US 2014/136876 discloses a complementary output generator module. US Patent Application Publication US 2010/0122007 discloses a microcontroller with configurable logic array.

Hence there is a need for a way to create PWM signals to control downstream power devices, such as synchronous rectifiers, that require little or no processor computation, and that respond to asynchronous events such as current limits on the source PWM signals. This and other objects can be achieved by an apparatus, microcontroller and method as defined in the independent claims. Further enhancements are characterized in the dependent claims.

According to an embodiment, an apparatus for generating a pulse width modulation (PWM) signal from a logical combination of two other PWM signals may comprise: a first PWM generator adapted for generating a first PWM signal; a second PWM generator adapted for generating a second PWM signal; and first combinatorial logic adapted for receiving the first and second PWM signals and generating a third PWM signal therefrom.

According to a further embodiment, the first combinatorial logic may comprise a plurality of logic functions. According to a further embodiment, the plurality of logic functions may be selected from any one or more of the group consisting of AND, NAND, OR, NOR, XOR and NXOR gate logic. According to a further embodiment, the first PWM generator may be adapted for generating the first PWM signal and an inverse first PWM signal. According to a further embodiment, the first and the inverse first PWM signals may be coupled to the first combinatorial logic. According to a further embodiment, the second PWM generator may be adapted for generating the second PWM signal and an inverse second PWM signal. According to a further embodiment, the second and the inverse second PWM signals may be coupled to the first combinatorial logic. According to a further embodiment, second combinatorial logic may be adapted for receiving the first and second PWM signals and generating a fourth PWM signal therefrom. According to a further embodiment, the second combinatorial logic may comprise a plurality of logic functions. According to a further embodiment, the first and the inverse first PWM signals may be coupled to second combinatorial logic. According to a further embodiment, the second and the inverse second PWM signals may be coupled to second combinatorial logic.

According to a further embodiment, the plurality of logic functions may be selectable. According to a further embodiment, the selectable plurality of logic functions may be programmable. According to a further embodiment, the programmable selection of the plurality of logic functions may be stored in a memory. According to a further embodiment, the memory may be at least one configuration register. According to a further embodiment, the plurality of logic functions may be selectable, the selection thereof may be programmable, and the programmable selection of the plurality of logic functions may be stored in a memory. According to a further embodiment, first sequential logic may be adapted for receiving the first and second PWM signals and generating the third PWM signal therefrom. According to a further embodiment, second sequential logic may be adapted for receiving the first and second PWM signals and generating the fourth PWM signal therefrom. According to a further embodiment, the first sequential logic may be selected from the group consisting of synchronous and asynchronous sequential logic. According to a further embodiment, a microcontroller that may comprise the PWM apparatus and be adapted to select certain ones of the plurality of logic functions thereof.

According to another embodiment, a method for generating a pulse width modulation (PWM) signal from a logical combination of two other PWM signals may comprise the steps of: generating a first PWM signal with a first PWM generator; generating a second PWM signal with a second PWM generator; and generating a third PWM signal from a logical combination of the first and second PWM signals.

According to a further embodiment of the method, the logical combination may be selected from the group consisting of AND, NAND, OR, NOR, XOR and NXOR logic. According to a further embodiment of the method, may comprise the step of generating a fourth PWM signal from a second logical combination of the first and second PWM signals. According to a further embodiment of the method, may comprise the step of generating a dead time between the third and fourth PWM signals. According to a further embodiment of the method, may comprise the step of substituting an asynchronous PWM signal for the third PWM signal. According to a further embodiment of the method, the asynchronous PWM signal may be a current limit PWM signal. According to a further embodiment of the method, may comprise the step of generating the third PWM signal from a sequential logic combination of the first and second PWM signals.

According to yet another embodiment, a method for generating a pulse width modulation (PWM) signal from a sequential logic combination of two other PWM signals may comprise the steps of: generating a first PWM signal with a first PWM generator; generating a second PWM signal with a second PWM generator; and generating a third PWM signal from a sequential logic combination of the first and second PWM signals.

A more complete understanding of the present disclosure may be acquired by referring to the following description taken in conjunction with the accompanying drawings wherein:
Figure 1 illustrates schematic block diagrams of PWM generators with dead time logic, according to the teachings of this disclosure;
Figures 2, 2A, 3 and 3A illustrate schematic diagrams of PWM combinatorial logic blocks, according to specific example embodiments of this disclosure;
Figure 4 illustrates a schematic block diagram of synchronous/asynchronous PWM selection and dead time logic, according to the teachings of this disclosure;
Figure 5 illustrates a PWM macro block in a microcontroller comprising multiple PWM generators, a combinatorial logic block and polarity selection, according to specific example embodiments of this disclosure;
Figure 5A illustrates a PWM macro block in a microcontroller comprising multiple PWM generators, a combinatorial and sequential logic block, and polarity selection, according to specific example embodiments of this disclosure;
Figure 6 illustrates a schematic diagram of an H-bridge primary stage and secondary stage synchronous FET rectifiers, according to the teachings of this disclosure;
Figure 7 illustrates a schematic timing diagram for PWM signals ORed together to provide synchronous rectification control when a SMPS is in continuous conduction mode, according to the teachings of this disclosure;
Figure 8 illustrates a schematic timing diagram for diagram for PWM signals ANDed together to provide synchronous rectification control when a SMPS is in a dis continuous conduction mode, according to the teachings of this disclosure;
Figure 9 illustrates a schematic timing diagram for PWM signals NORed together to provide rectification for an interleaved forward converter, according to the teachings of this disclosure; and
Figure 10 illustrates a schematic timing diagram for PWM signals ANDed together to provide LED lighting or motor control, according to the teachings of this disclosure.

While the present disclosure is susceptible to various modifications and alternative forms, specific example embodiments thereof have been shown in the drawings and are herein described in detail. It should be understood, however, that the description herein of specific example embodiments is not intended to limit the disclosure to the particular forms disclosed herein.

According to various embodiments of this disclosure, a user controllable creation of PWM signals that are the logical processing of other PWM signals may be provided with user selectable combinatorial and/or sequential logic functions.

According to various embodiments of this disclosure, a method may be provided to create "Derivative PWM" signals based on a plurality of input PWM signals. The various embodiments provide for the creation of PWM signals in a microcontroller device via combinatorial and/or sequential logic receiving source PWM signals. Microcontrollers are systems on a single integrated circuit die (chip) that may generally comprise a central processing unit, memory, a plurality of input/output ports, and a variety of peripheral devices.

A number of standard PWM generators produce PWM signals that may be used to drive the power stages for Full-Bridge, Feed-Forward, Push-Pull, Phase-Shift Zero Voltage Transition (ZVT), and other switched mode power supply (SMPS) conversion topologies. These PWM signals may be fed to the combinatorial logic block disclosed and claimed herein. The user (via control registers) may select the appropriate PWM signals as the operands, and select the desired logic function(s) that operates on the input operands. The resultant combinatorial PWM signals may be used directly or may be fed through dead-time processing circuitry prior to outputting to an application circuit. In addition to the combinatorial logic functions, sequential logic functions may also be used to provide sequential PWM signals, e.g., synchronous sequential, asynchronous sequential, and/or sequential-combinatorial PWM signals.

Referring now to the drawings, the details of specific example embodiments are schematically illustrated. Like elements in the drawings will be represented by like numbers, and similar elements will be represented by like numbers with a different lower case letter suffix.

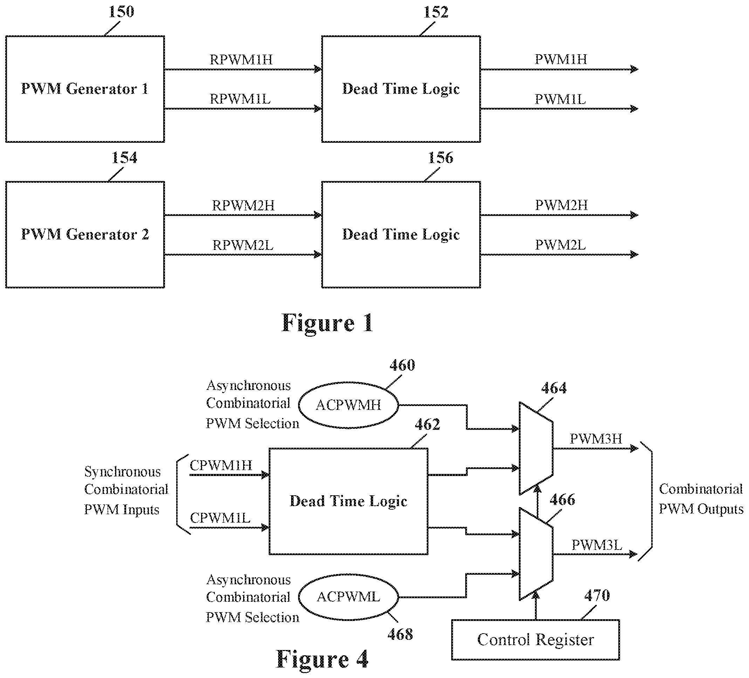

Referring to Figure 1, depicted are schematic block diagrams of PWM generators with dead time logic, according to the teachings of this disclosure. A first PWM generator 150 may produce raw first PWM signals RPWM1H and RPWM1L coupled to a first dead time logic 152 that may produce first PWM signals PWM1H and PWM1L, used to prevent "current shoot through" in SMPS power switches. A second PWM generator 154 may produce raw second PWM signals RPWM2H and RPWM2L coupled to a second dead time logic 156 that may produce second PWM signals PWM2H and PWM2L, used to prevent "current shoot through" in SMPS power switches.

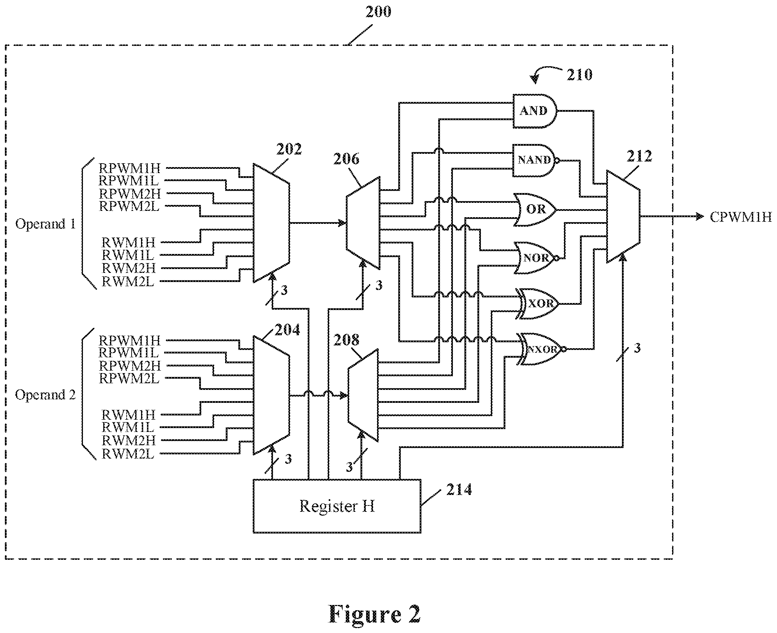

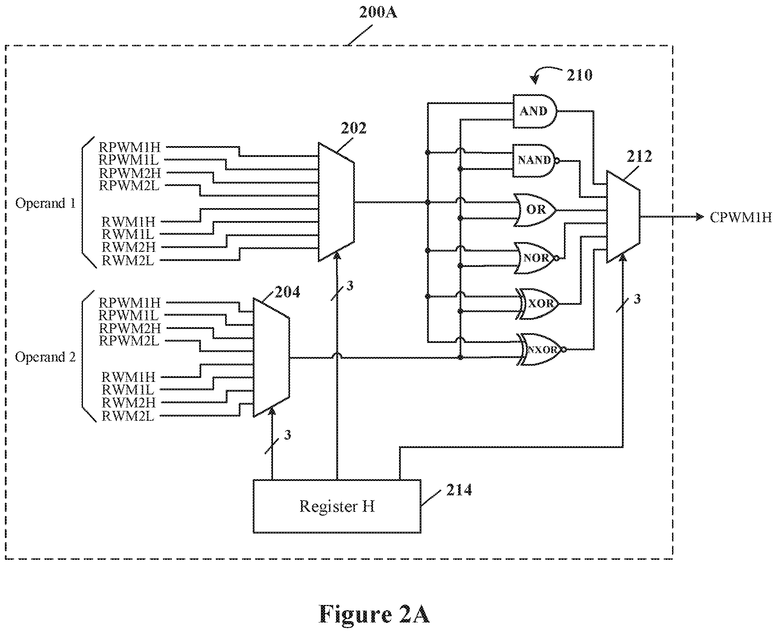

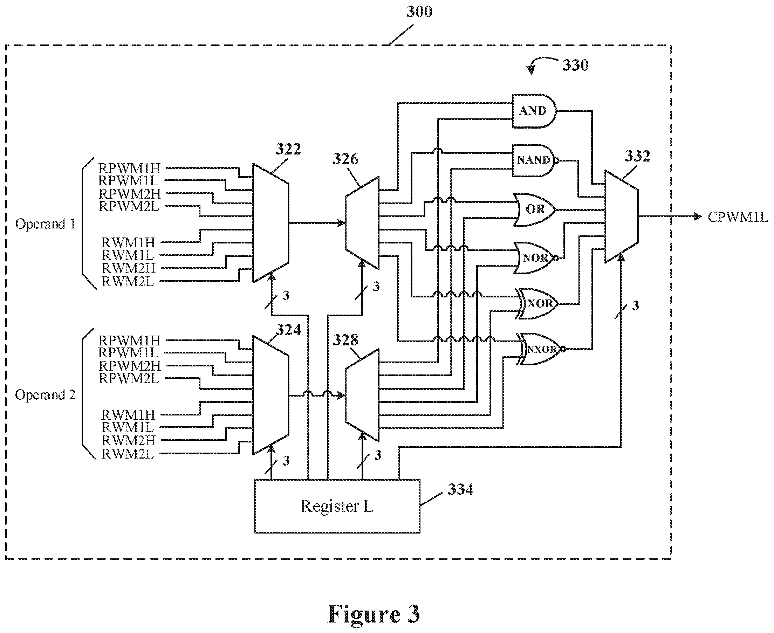

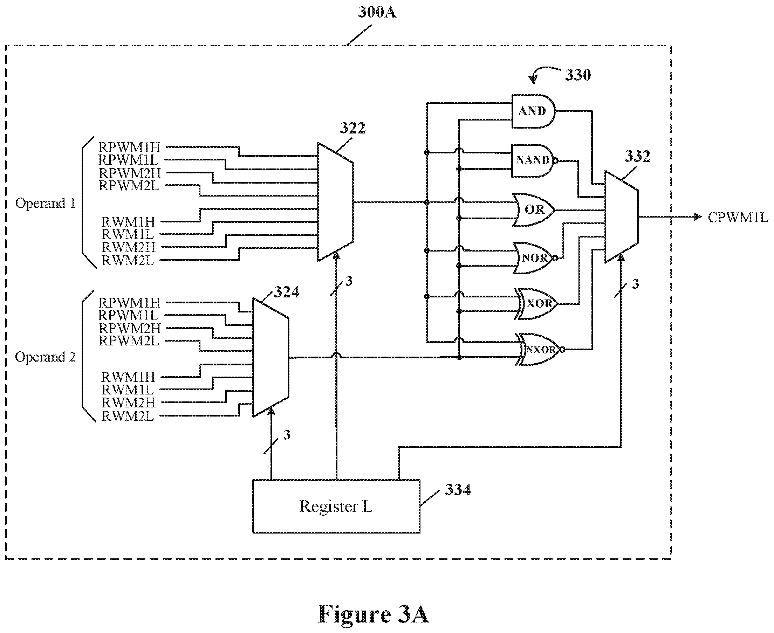

Referring to Figures 2, 2A, 3 and 3A; depicted are schematic diagrams of PWM combinatorial logic blocks, according to specific example embodiments of this disclosure. In Figure 2 a combinatorial PWM module 200 has signals RPWM1H, RPWM1L, RPWM2H, RPWM2L, PWM1H, PWM1L, PWM2H and PWM2L coupled to a first multiplexer 202 and a second multiplexer 204. The output of the first multiplexer 202 is coupled to an input of a first de-multiplexer 206, and the output of the second multiplexer 204 is coupled to an input of a second de-multiplexer 208. The outputs of the first and second de-multiplexers 206 and 208 are coupled to first and second inputs, respectively, of a plurality of different logic gates 210. A third multiplexer 212 has its inputs coupled to respective outputs of the plurality of different logic gates 210 and is used to select which output of the plurality of different logic gates 210 will be coupled to the output of the third multiplexer 212 to provide the PWM signal CPWM1H. A first register 214 may be used to hold the multiplexer and de-multiplexer input/output steering selections, and may be programmed by a user of this combinatorial PWM module 200.

In Figure 2A a combinatorial PWM module 200A has signals RPWM1H, RPWM1L, RPWM2H, RPWM2L, PWM1H, PWM1L, PWM2H and PWM2L coupled to a first multiplexer 202 and a second multiplexer 204. The output of the first multiplexer 202 is coupled to first inputs of a plurality of different logic gates 210. The output of the second multiplexer 204 is coupled to second inputs of the plurality of different logic gates 210. A third multiplexer 212 has its inputs coupled to respective outputs of the plurality of different logic gates 210 and is used to select which output of the plurality of different logic gates 210 will be coupled to the output of the third multiplexer 212 to provide the PWM signal CPWM1H. A first register 214 may be used to hold the multiplexer and de-multiplexer input/output steering selections, and may be programmed by a user of this combinatorial PWM module 200A.

In Figure 3 a combinatorial PWM module 200 has signals RPWM1H, RPWM1L, RPWM2H, RPWM2L, PWM1H, PWM1L, PWM2H and PWM2L coupled to a fourth multiplexer 322 and a fifth multiplexer 324. The output of the fourth multiplexer 322 is coupled to an input of a third de-multiplexer 326, and the output of the fifth multiplexer 324 is coupled to an input of a fourth de-multiplexer 328. The outputs of the third and fourth de-multiplexers 326 and 328 are coupled to first and second inputs, respectively, of a plurality of different logic gates 330. A sixth multiplexer 332 has its inputs coupled to respective outputs of the plurality of different logic gates 330 and is used to select which output of the plurality of different logic gates 330 will be coupled to the output of the sixth multiplexer 332 to provide the PWM signal CPWM1L. A second register 334 may be used to hold the multiplexer and de-multiplexer input/output steering selections, and may be programmed by a user of this combinatorial PWM module 300.

In Figure 3A a combinatorial PWM module 300A has signals RPWM1H, RPWM1L, RPWM2H, RPWM2L, PWM1H, PWM1L, PWM2H and PWM2L coupled to a fourth multiplexer 322 and a fifth multiplexer 324. The output of the fourth multiplexer 322 is coupled to first inputs of a plurality of different logic gates 330. The output of the fifth multiplexer 324 is coupled to second inputs of the plurality of different logic gates 330. A sixth multiplexer 332 has its inputs coupled to respective output of the plurality of different logic gates 330 and is used to select which output of the plurality of different logic gates 330 will be coupled to the output of the sixth multiplexer 332 to provide the PWM signal CPWM1HL. A second register 334 may be used to hold the multiplexer and de-multiplexer input/output steering selections, and may be programmed by a user of this combinatorial PWM module 300A.

The multiplexers and/or de-multiplexers shown in Figures 2, 2A, 3 and/or 3A may be replaced by an X-Y switch matrix and controlled from the register(s) shown. It is contemplated and within the scope of this disclosure that one having ordinary skill in digital electronic integrated circuit design and the benefit of this disclosure could come up with other circuit designs that would function accordingly.

Referring to Figure 4, depicted is a schematic block diagram of synchronous/asynchronous PWM selection and dead time logic, according to the teachings of this disclosure. In Figure 4, multiplexers 464 and 466 are used two switch between synchronous PWM signals CPWM1H and CPWM1L, and asynchronous PWM signals ACPWMH 460 and ACPWML 468, e.g., overcurrent alarm/trip. The CPWM1H and CPWM1L PWM signals from the combinatorial PWM modules 200, 200a, 300 and/or 300A may be further "conditioned" with dead time logic 462. A register 470 may be used to store and control selection between the synchronous and asynchronous PWM signals. The outputs PWM3H and PWM3L from the multiplexers 464 and 466, respectively, may be used to drive SMPS circuits. Users may program the control register 470 to select either the dead-time processed versions of the combinatorial PWM signals or use the outputs of the combinatorial block outputs directly.

Referring to Figure 5, depicted is a PWM macro block in a microcontroller comprising multiple PWM generators, a combinatorial logic block and polarity selection, according to specific example embodiments of this disclosure. A microcontroller, generally represented by the numeral 500, may comprise a digital processor and memory 552, a first PWM generator and dead time logic 550, a second PWM generator and dead time logic 552, combinatorial logic 556, a plurality of polarity selection XOR gates 558 and a combination storage register 560. The combinatorial logic 556 may comprise the circuits shown in Figures 2, 2A, 3, 3A or any other comparable in function logic circuit design. The combinatorial logic 556 and plurality of polarity selection XOR gates 558 may provide for user controlled selection of various additional PWM signals derived from the PWM signals provided by the first and second PWM generators 550 and 552. The combination register 560 may use a plurality of bits to store the combinatorial logic configurations used in the combinatorial logic 556. The combination register 560 may be part of the digital processor memory 554 or a separate storage register in the microcontroller 500. The PWM outputs may be multiplexed on external connection nodes (pins) of the microcontroller 500 package and the desired configurations of these multiplexed pins may be programmed and stored in configuration registers (not shown).

Referring to Figure 5A, depicted is a PWM macro block in a microcontroller comprising multiple PWM generators, a combinatorial and sequential logic block, and polarity selection; according to specific example embodiments of this disclosure. The microcontroller 500a shown in Figure 5A functions in substantially the same way as the microcontroller 500 shown in Figure 5 and may further comprise both combinatorial and sequential logic 556a. Sequential logic is a type of logic whose output depends not only on the present value of its input(s) but on a sequence of past inputs, e.g., sequential logic may be thought of as combinatorial logic with memory. Sequential logic may further be defined as being either synchronous or asynchronous, where synchronous sequential logic relies upon a clock input, which may be one of the PWM signals selected; and asynchronous sequential logic is not synchronized by a clock signal. There are many examples of both synchronous and asynchronous sequential logic, and are contemplated herein for all purposes.

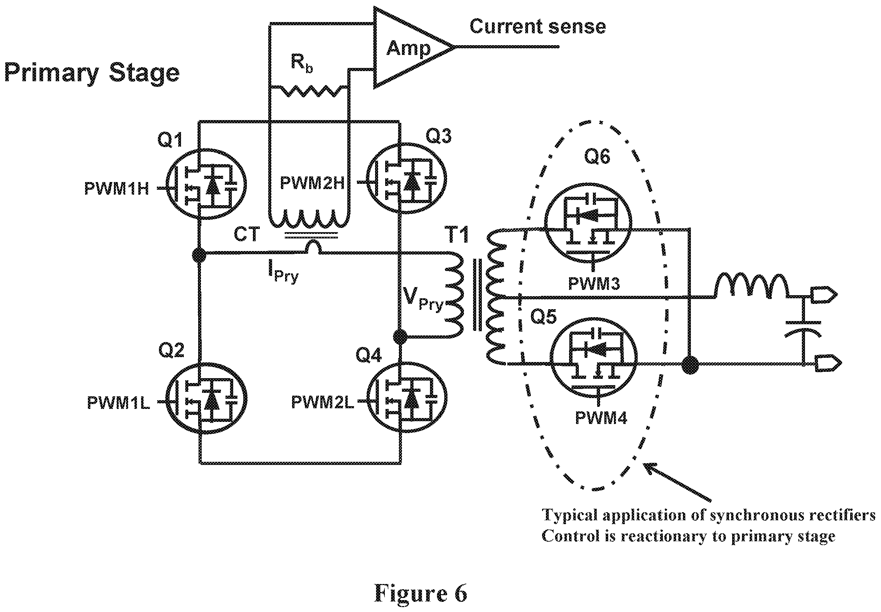

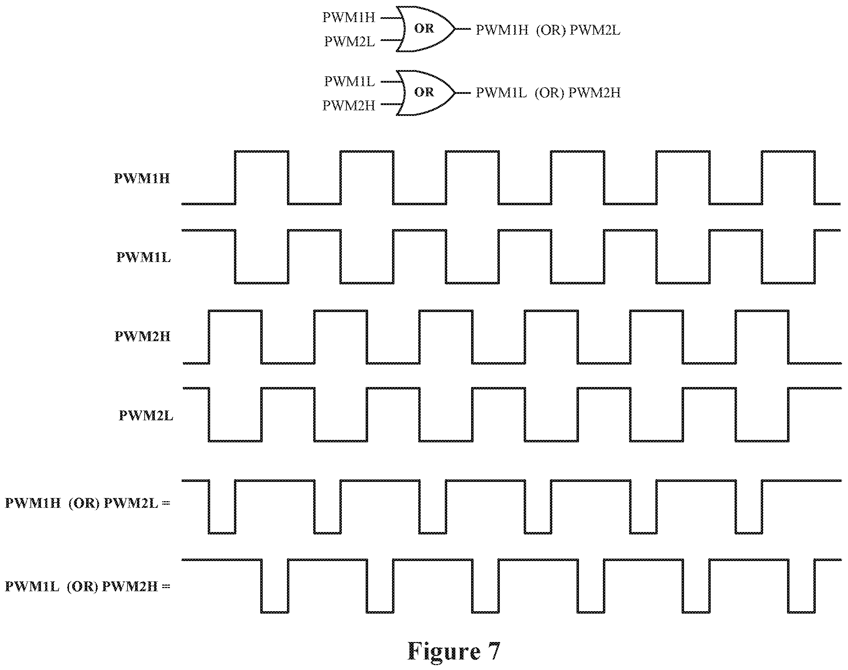

Referring to Figure 6, depicted is a schematic diagram of an H-bridge primary stage and secondary stage synchronous FET rectifiers, according to the teachings of this disclosure. The PWM signals derived in Figures 1-4 may be used to drive the FET power switches shown in Figure 6. Synchronous rectifiers (Sync-FETs) are widely used due to their superior power efficiency compared to standard rectifier diodes. The control of (Sync-FETs) is challenging due to the need to be reactive to what is happening in the primary power conversion stage in front of the synchronous rectifiers. Existing (Sync-FET) control methods require additional control circuitry, or additional computation resources to plan and react to events (such as current limits) in proceeding power stages. The combinatorial PWM module shown in Figures 2, 2A, 3 and/or 3A create PWM signals to control synchronous rectifiers that require little processor computation, and that respond to asynchronous events such as current limits on the source PWM signals. A few example PWM waveform timing diagrams and descriptions are as follows:
Referring to Figure 7, depicted is a schematic timing diagram for PWM signals ORed together to provide synchronous rectification control when a SMPS is in continuous conduction mode, according to the teachings of this disclosure. PWM signals PWM1H is ORed with PWM2L, and PWM1L is ORed with PWM2H to produce two new PWM signals as shown in Figure 7. These new PWM signals may be used to control synchronous rectifiers with the SMPS is in continuous conduction mode.

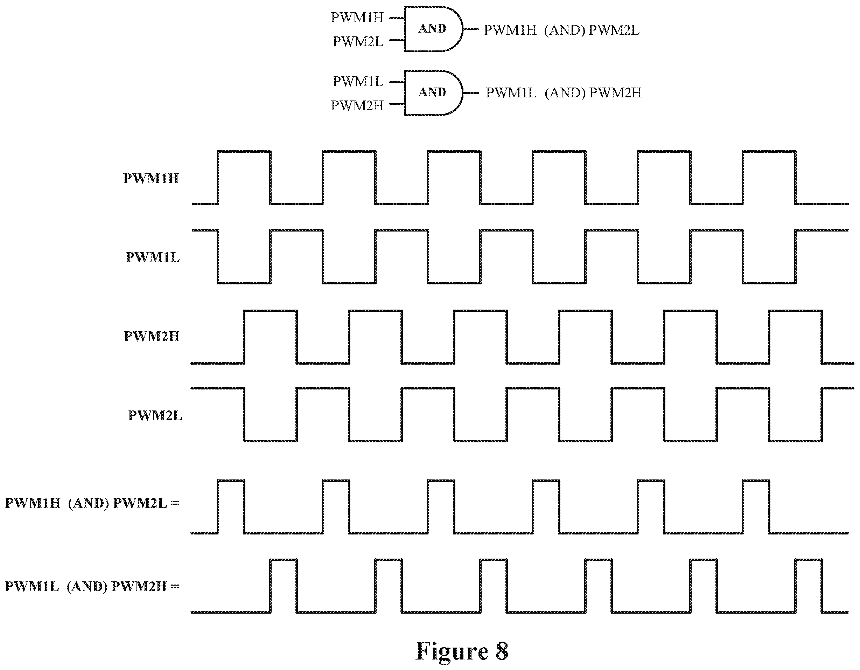

Referring to Figure 8, depicted is a schematic timing diagram for diagram for PWM signals ANDed together to provide synchronous rectification control when a SMPS is in discontinuous conduction mode, according to the teachings of this disclosure. PWM signals PWM1H is ANDed with PWM2L, and PWM1L is ANDed with PWM2H to produce two new PWM signals as shown in Figure 8. These new PWM signals may be used to control synchronous rectifiers when the PSU is in discontinuous conduction mode.

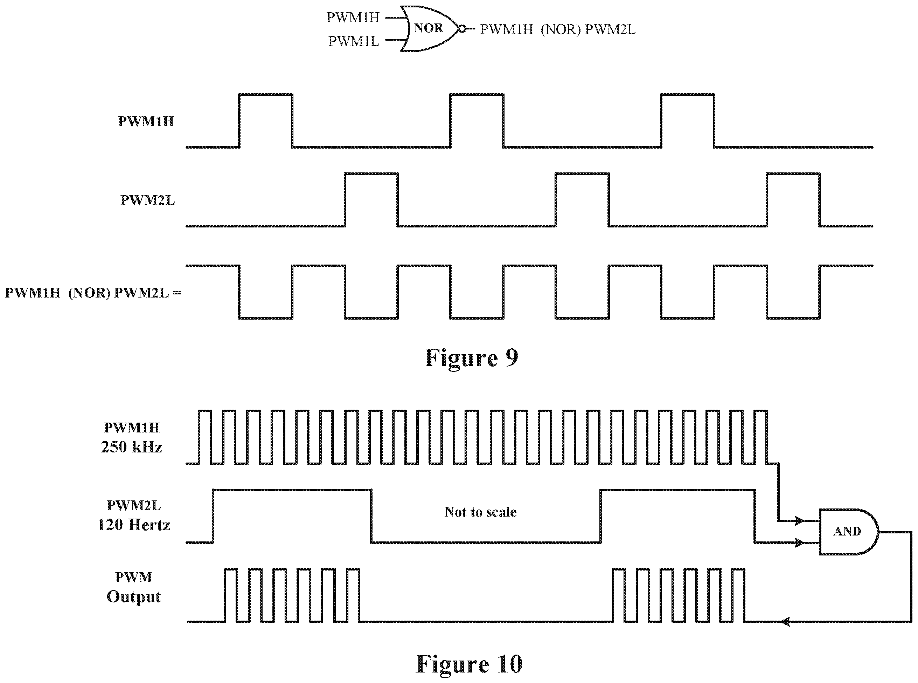

Referring to Figure 9, depicted is a schematic timing diagram for PWM signals NORed together to provide rectification for an interleaved forward converter, according to the teachings of this disclosure. Figure 9 shows the inverse result of when the PWM1H signal is NORed with the PWM2L signal. This new PWM signal may be used to control interleaved synchronous rectification in a SMPS.

Referring to Figure 10, depicted is a schematic timing diagram for PWM signals ANDed together to provide LED lighting or motor control, according to the teachings of this disclosure. Note, the signals shown are not drawn to scale. This circuit may effectively control LED lamp brightness or motor speed. A benefit of using sequential-combinatorial logic is that the much higher frequency PWM1 signal may be turned off when the lower frequency PWM2 is at a logic low to conserve power and then when the PWM2 signal goes back to a logic high then the PWM1 signal may be synchronized (circuit not shown), *e*.*g*., phase-locked, to the rising edge of the PWM2 signal, thereby providing a clean (spike-less) PWM output signal from the AND gate.

## Claims

1. An apparatus for generating a pulse width modulation (PWM) signal from a logical combination of two other PWM signals, the PWM signal being applied to a switched mode power supply converter, comprising:
a first PWM generator (150; 550) adapted for generating a first PWM signal;
a second PWM generator (154; 552) adapted for generating a second PWM signal; and
first combinatorial logic (200; 300; 556);
**characterized in that**
the first and second PWM generators (150; 550; 154; 552) are controllable and the first combinatorial logic (200; 300; 556) comprises a plurality of selectable logic functions (210; 330) and is further adapted for:
receiving the first and second PWM signals, and
generating a third PWM signal from a sequential logic combination of the first and second PWM signals by variably selecting from the plurality of selectable logic functions (210; 330) according to an output mode of the switched mode power supply converter, the output mode being one of a continuous conduction mode, and a discontinuous conduction mode.

2. The apparatus according to claim 1, wherein the plurality of logic functions (210) are selected from any one or more of the group consisting of AND, NAND, OR, NOR, XOR and NXOR gate logic.

3. The apparatus according to one of the preceding claims, wherein the first PWM generator (150; 550) is adapted for generating the first PWM signal and an inverse first PWM signal, wherein the first and the inverse first PWM signals are coupled to the first combinatorial logic and wherein the second PWM generator (154; 552) is adapted for generating the second PWM signal and an inverse second PWM signal, wherein the second and the inverse second PWM signals are coupled to the first combinatorial logic.

4. The apparatus according to one of the preceding claims, further comprising second combinatorial logic adapted for receiving the first and second PWM signals and generating a fourth PWM signal therefrom, wherein the second combinatorial logic comprises a plurality of logic functions, wherein the second combinatorial logic optionally receives the inverse first PWM signals and/or the inverse second PWM signals.

5. The apparatus according to one of the preceding claims, wherein the selectable plurality of logic functions (210; 330) are programmable, wherein preferably the programmable selection of the plurality of logic functions are stored in a memory, preferably at least one configuration register (214; 334; 560).

6. The apparatus according to one of the preceding claims, further comprising first sequential logic (556a) adapted for receiving the first and second PWM signals and generating the third PWM signal therefrom.

7. The apparatus according to claim 4, further comprising second sequential logic adapted for receiving the first and second PWM signals and generating the fourth PWM signal therefrom.

8. The apparatus according to claim 6, wherein the first sequential logic (556a) is selected from the group consisting of synchronous and asynchronous sequential logic.

9. A microcontroller comprising the PWM apparatus according to one of the preceding claims, wherein the microcontroller (500a) is adapted to select certain ones of the plurality of logic functions (210; 330).

10. A method for generating a pulse width modulation (PWM) signal, the PWM signal to be applied to a switched mode power supply converter, from a logical combination of two other PWM signals, said method comprising the steps of:
generating a first PWM signal with a controllable first PWM generator (150; 550);
generating a second PWM signal with a controllable second PWM generator (154; 552); and
generating a third PWM signal from a logical combination of the first and second PWM signals by variably selecting from a plurality of selectable logic functions (210; 330) according to an output mode of the switched mode power supply converter, the output mode being one of a continuous conduction mode, and a discontinuous conduction mode.

11. The method according to claim 10, wherein the logical combination is selected from the group consisting of AND, NAND, OR, NOR, XOR and NXOR logic.

12. The method according to claim 10 or claim 11, further comprising the step of generating a fourth PWM signal from a second logical combination of the first and second PWM signals.

13. The method according to one of the claims 10 - 12, further comprising the step of generating a dead time between the third and fourth PWM signals.

14. The method according to one of claims 10 - 13, further comprising the step of substituting an asynchronous PWM signal for the third PWM signal, wherein the asynchronous PWM signal is optionally a current limit PWM signal.

15. The method according to one of claims 10 - 14, further comprising the step of generating the third PWM signal from a sequential logic combination of the first and second PWM signals.

## Patentansprüche

1. Vorrichtung zum Erzeugen eines Pulsweitenmodulations- (PWM) Signals aus einer logischen Kombination von zwei anderen PWM-Signalen, wobei das PWM-Signal auf einen Schaltnetzteilwandler angewendet wird, wobei die Vorrichtung aufweist:
einen ersten PWM-Generator (150; 550), adaptiert zum Erzeugen eines ersten PWM-Signals;
einen zweiten PWM-Generator (154; 552), adaptiert zum Erzeugen eines zweiten PWM-Signals; und
erste kombinatorische Logik (200; 300; 556);
**dadurch gekennzeichnet, dass**
die ersten und zweiten PWM-Generatoren (150; 550; 154; 552) steuerbar sind und die erste kombinatorische Logik (200; 300; 556) eine Vielzahl von auswählbaren Logikfunktionen (210; 330) aufweist und weiterhin adaptiert ist:
die ersten und zweiten PWM-Signale zu empfangen, und
durch variables Auswählen aus der Vielzahl von auswählbaren Logikfunktionen (210; 330) gemäß einem Ausgabemodus des Schaltnetzteilwandlers ein drittes PWM-Signal über eine sequentielle Logikkombination aus den ersten und zweiten PWM-Signalen zu erzeugen, wobei der Ausgabemodus einer aus einem kontinuierlichen Stromflussmodus und einem diskontinuierlichen Stromflussmodus ist.

2. Vorrichtung gemäß Anspruch 1, wobei die Vielzahl von Logikfunktionen (210) aus einer beliebigen oder mehreren der Gruppe bestehend aus AND, NAND, OR, NOR, XOR und NXOR Gatterlogik ausgewählt wird.

3. Vorrichtung gemäß einem der vorherigen Ansprüche, wobei der erste PWM-Generator (150; 550) zum Erzeugen des ersten PWM-Signals und eines inversen ersten PWM-Signals adaptiert ist, wobei das erste und das inverse erste PWM-Signal mit der ersten kombinatorischen Logik gekoppelt sind und wobei der zweite PWM-Generator (154; 552) zum Erzeugen des zweiten PWM-Signals und eines inversen zweiten PWM-Signals adaptiert ist, wobei das zweite und das inverse zweite PWM-Signal mit der ersten kombinatorischen Logik gekoppelt sind.

4. Vorrichtung gemäß einem der vorherigen Ansprüche, die weiterhin zweite kombinatorische Logik aufweist, die zum Empfangen der ersten und zweiten PWM-Signale und Erzeugen eines vierten PWM-Signals aus diesen adaptiert ist, wobei die zweite kombinatorische Logik eine Vielzahl von Logikfunktionen aufweist, wobei die zweite kombinatorische Logik optional die inversen ersten PWM-Signale und/oder die inversen zweiten PWM-Signale empfängt.

5. Vorrichtung gemäß einem der vorherigen Ansprüche, wobei die auswählbare Vielzahl von Logikfunktionen (210; 330) programmierbar ist, wobei die programmierbare Auswahl der Vielzahl von Logikfunktionen vorzugsweise in einem Speicher, vorzugsweise zumindest einem Konfigurationsregister (214; 334; 560), gespeichert wird.

6. Vorrichtung gemäß einem der vorherigen Ansprüche, die weiterhin erste sequentielle Logik (556a) aufweist, die zum Empfangen der ersten und zweiten PWM-Signale und Erzeugen des dritten PWM-Signals aus diesen adaptiert ist.

7. Vorrichtung gemäß Anspruch 4, die weiterhin zweite sequentielle Logik aufweist, die zum Empfangen der ersten und zweiten PWM-Signale und Erzeugen des vierten PWM-Signals aus diesen adaptiert ist.

8. Vorrichtung gemäß Anspruch 6, wobei die erste sequentielle Logik (556a) aus der Gruppe bestehend aus synchroner und asynchroner sequentieller Logik ausgewählt wird.

9. Mikrocontroller, der die PWM-Vorrichtung gemäß einem der vorherigen Ansprüche aufweist, wobei der Mikrocontroller (500a) adaptiert ist, bestimmte der Vielzahl von Logikfunktionen (210; 330) auszuwählen.

10. Verfahren zum Erzeugen eines Pulsweitenmodulations- (PWM) Signals aus einer logischen Kombination von zwei anderen PWM-Signalen, wobei das PWM-Signal auf einen Schaltnetzteilwandler angewendet werden soll, wobei das Verfahren die nachfolgenden Schritte aufweist:
Erzeugen eines ersten PWM-Signals mit einem steuerbaren ersten PWM-Generator (150; 550);
Erzeugen eines zweiten PWM-Signals mit einem steuerbaren zweite PWM-Generator (154; 552); und
durch variables Auswählen aus einer Vielzahl von auswählbaren Logikfunktionen (210; 330) gemäß einem Ausgabemodus des Schaltnetzteilwandlers Erzeugen eines dritten PWM-Signals aus einer logischen Kombination der ersten und zweiten PWM-Signale, wobei der Ausgabemodus einer aus einem kontinuierlichen Stromflussmodus und einem diskontinuierlichen Stromflussmodus ist.

11. Verfahren gemäß Anspruch 10, wobei die logische Kombination ausgewählt wird aus der Gruppe bestehend aus AND, NAND, OR, NOR, XOR und NXOR Logik.

12. Verfahren gemäß Anspruch 10 oder Anspruch 11, das weiterhin den Schritt des Erzeugens eines vierten PWM-Signals aus einer zweiten logischen Kombination der ersten und zweiten PWM-Signale aufweist.

13. Verfahren gemäß einem der Ansprüche 10 bis 12, das weiterhin den Schritt des Erzeugens einer Totzeit zwischen den dritten und vierten PWM-Signalen aufweist.

14. Verfahren gemäß einem der Ansprüche 10 bis 13, das weiterhin den Schritt des Substituierens eines asynchronen PWM-Signals für das dritte PWM-Signal aufweist, wobei das asynchrone PWM-Signal optional ein Strombegrenzungs-PWM-Signal ist.

15. Verfahren gemäß einem der Ansprüche 10 bis 14, das weiterhin den Schritt des Erzeugens des dritten PWM-Signals aus einer sequentiellen Logikkombination der ersten und zweiten PWM-Signale aufweist.

## Revendications

1. Appareil destiné à générer un signal de modulation d'impulsions en durée (PWM) à partir d'une combinaison logique de deux autres signaux de modulation PWM, le signal de modulation PWM étant appliqué à un convertisseur d'alimentation à découpage, comprenant :
un premier générateur de signal de modulation PWM (150 ; 550) apte à générer un premier signal de modulation PWM ;
un second générateur de signal de modulation PWM (154 ; 552) apte à générer un deuxième signal de modulation PWM ; et
une première logique combinatoire (200 ; 300 ; 556) ;
**caractérisé en ce que** :
les premier et second générateurs de signal de modulation PWM (150 ; 550 ; 154 ; 552) sont commandables, et la première logique combinatoire (200 ; 300 ; 556) comprend une pluralité de fonctions logiques sélectionnables (210 ; 330), et est en outre apte à :
recevoir les premier et deuxième signaux de modulation PWM ; et
générer un troisième signal de modulation PWM à partir d'une combinaison logique séquentielle des premier et deuxième signaux de modulation PWM en choisissant de manière variable parmi la pluralité de fonctions logiques sélectionnables (210 ; 330) selon un mode de sortie du convertisseur d'alimentation à découpage, le mode de sortie correspondant à l'un parmi un mode de conduction continu et un mode de conduction discontinu.

2. Appareil selon la revendication 1, dans lequel les fonctions de la pluralité de fonctions logiques (210) sont choisies parmi une ou plusieurs fonctions logiques du groupe constitué par une logique de porte « ET », « NON-ET », « OU », « NON-OU », « OU exclusif » et « NON-OU exclusif ».

3. Appareil selon l'une quelconque des revendications précédentes, dans lequel le premier générateur de signal de modulation PWM (150 ; 550) est apte à générer le premier signal de modulation PWM et un premier signal de modulation PWM inverse, le premier signal de modulation PWM et le premier signal de modulation PWM inverse étant couplés à la première logique combinatoire, et dans lequel le second générateur de signal de modulation PWM (154 ; 552) est apte à générer le deuxième signal de modulation PWM et un deuxième signal de modulation PWM inverse, le deuxième signal de modulation PWM et le deuxième signal de modulation PWM inverse étant couplés à la première logique combinatoire.

4. Appareil selon l'une quelconque des revendications précédentes, comprenant en outre une seconde logique combinatoire apte à recevoir les premier et deuxième signaux de modulation PWM et à générer un quatrième signal de modulation PWM à partir de ceux-ci, la seconde logique combinatoire comprenant une pluralité de fonctions logiques, la seconde logique combinatoire recevant facultativement les premiers signaux de modulation PWM inverses et/ou les deuxièmes signaux de modulation PWM inverses.

5. Appareil selon l'une quelconque des revendications précédentes, dans lequel la pluralité sélectionnable de fonctions logiques (210 ; 330) est programmable, la sélection programmable de la pluralité de fonctions logiques étant, de préférence, stockée dans une mémoire, de préférence dans au moins un registre de configuration (214 ; 334 ; 560).

6. Appareil selon l'une quelconque des revendications précédentes, comprenant en outre une première logique séquentielle (556a) apte à recevoir les premier et deuxième signaux de modulation PWM et à générer le troisième signal de modulation PWM à partir de ceux-ci.

7. Appareil selon la revendication 4, comprenant en outre une seconde logique séquentielle apte à recevoir les premier et deuxième signaux de modulation PWM et à générer le quatrième signal de modulation PWM à partir de ceux-ci.

8. Appareil selon la revendication 6, dans lequel la première logique séquentielle (556a) est sélectionnée à partir du groupe constitué par une logique séquentielle synchrone et une logique séquentielle asynchrone.

9. Microcontrôleur comprenant l'appareil de modulation PWM selon l'une quelconque des revendications précédentes, le microcontrôleur (500a) étant apte à sélectionner certaines fonctions parmi la pluralité de fonctions logiques (210 ; 330).

10. Procédé de génération d'un signal de modulation d'impulsions en durée (PWM), le signal de modulation PWM devant être appliqué à un convertisseur d'alimentation à découpage, à partir d'une combinaison logique de deux autres signaux de modulation PWM, ledit procédé comprenant les étapes ci-dessous consistant à :
générer un premier signal de modulation PWM avec un premier générateur de signal de modulation PWM commandable (150 ; 550) ;
générer un deuxième signal de modulation PWM avec un second générateur de signal de modulation PWM commandable (154 ; 552) ; et
générer un troisième signal de modulation PWM à partir d'une combinaison logique des premier et deuxième signaux de modulation PWM en choisissant de manière variable parmi une pluralité de fonctions logiques sélectionnables (210 ; 330) selon un mode de sortie du convertisseur d'alimentation à découpage, le mode de sortie correspondant à l'un parmi un mode de conduction continu et un mode de conduction discontinu.

11. Procédé selon la revendication 10, dans lequel la combinaison logique est sélectionnée à partir du groupe constitué par une logique « ET », « NON-ET », « OU », « NON-OU », « OU exclusif » et « NON-OU exclusif ».

12. Procédé selon la revendication 10 ou 11, comprenant en outre l'étape consistant à générer un quatrième signal de modulation PWM à partir d'une seconde combinaison logique des premier et deuxième signaux de modulation PWM.

13. Procédé selon l'une quelconque des revendications 10 à 12, comprenant en outre l'étape consistant à générer un temps mort entre les troisième et quatrième signaux de modulation PWM.

14. Procédé selon l'une quelconque des revendications 10 à 13, comprenant en outre l'étape consistant à substituer un signal de modulation PWM asynchrone au troisième signal de modulation PWM, le signal de modulation PWM asynchrone étant facultativement un signal de modulation PWM de limitation de courant.

15. Procédé selon l'une quelconque des revendications 10 à 14, comprenant en outre l'étape consistant à générer le troisième signal de modulation PWM à partir d'une combinaison logique séquentielle des premier et deuxième signaux de modulation PWM.
